# EUROPÄISCHE PATENTSCHRIFT

(11) **EP 0 255 658 B1**
(45) Veröffentlichungstag und Bekanntmachung des Hinweises auf die Patenterteilung: **20.01.1993**
(21) Anmeldenummer: 87110611.8
(22) Anmeldetag: 22.07.1987
(51) Int. Cl.: G01R 31/06, H02H 11/00

(54) **Anordnung zur Beeinflussung eines Schaltgerätes**
Device for influencing a switching apparatus
Dispositif pour influencer un appareil d'interruption

(30) Priorität: 04.08.1986 DE 3626399
(43) Veröffentlichungstag der Anmeldung: 10.02.1988
(73) Patentinhaber: SIEMENS AKTIENGESELLSCHAFT, 80333 München (DE)
(72) Erfinder: Trenkler, Gerhard, Prof. Dr., D-3300 Braunschweig (DE); Maier, Reinhard, Dr., D-8522 Herzogenaurach (DE); Goth, Kurt, D-8510 Fürth (DE)

(56) Entgegenhaltungen:
- EP-A- 0 149 046
- US-A- 3 622 882
- US-A- 3 869 664
- ELEKTROTECHNIK UND MASCHININBAU, Band 100, Nr. 1, Januar 1983, Seiten 6-10, Wien, AT; M. RENTMEISTER: "Eine Methode zur Prüfung von Windungsschlüssen bei Läufern von Kommentatormaschinen"

## Beschreibung

Die Erfindung bezieht sich auf eine Anordnung zur Blockierung eines Schaltgerätes, vorzugsweise eines fernbetätigten Schaltgerätes zum Schalten von Verbrauchern, in Abhängigkeit von Verbrauchernetzzustandsdaten die sich aufgrund einer Fremdspannungseinspeisung in Verbindung mit einer nachgeschalteten Verbraucherstrom-und Verbraucherspannungs-Auswerteschaltung mit Soll- und Istwertvergleich ergeben.

Bei einer bekannten Anordnung der obengenannten Art (DE-OS 33 47 209 = EP-A-0 149 046) wird eine Meßspannung an das Verbrauchernetz gelegt, mit der ein Stromsensor in Reihe liegt. Durch Umschalten auf die einzelnen Phasen wird die Impedanz zwischen den einzelnen Phasen und gegen Erde erfaßt und die erfaßten Werte einer Verarbeitungsstufe zugeführt. Wird hier mit einer kleinen Spannung gearbeitet, so können Spannungsüberschläge und auch Windungsschlüsse, die erst bei höheren Windungsspannungen auftreten, mit einer derartigen Anordnung nicht erkannt werden. Wird jedoch mit einer größeren Spannung gearbeitet, so ist eine relativ aufwendige Schaltvorrichtung zum Umschalten auf die einzelnen Phasen erforderlich, da die volle Leistung geschaltet werden muß.

Zur Prüfung von Windungsschlüssen bei Läufern von Kommutatormaschinen ist es weiterhin bekannt (Elektrotechnik und Maschinenbau, Band 100, Nr. 1, Januar 1983, Seiten 6 - 10), bei ausgebautem Läufer eine Fremdspannung über ein Bürstenpaar auf den Kommutator des Läufers aufzubringen und nach Verdrehen des Läufers die Spannungsverläufe visuell miteinander zu vergleichen. Die Fremdspannung wird hier durch Aufladen eines Kondensators und anschließendes Entladen erzeugt.

Der vorliegenden Erfindung liegt die Aufgabe zugrunde, die Anordnung der obengenannten Art dahingehend zu verbessern, daß mit geringem Schaltungsaufwand auch eine Erfassung von Windungsschlüssen ermöglicht wird. Dies wird auf einfache Weise dadurch erreicht, daß ein Stoßgenerator zur Fremdspannungseinspeisung vorgesehen ist und daß die Auswerteschaltung die Spitzenwerte der Verbrauchermomentanleistung auswertet. Hierdurch wird eine noch sicherere und gegen Störspannungen unempfindliche Windungsschlußerfassung verwirklicht. Um mit einem Stoßgenerator für ein Mehrphasennetz auszukommen, ist es vorteilhaft, wenn der Stoßgenerator alle Phasen des Mehrphasennetzes gleichzeitig mit einem Stoßspannungsimpuls beaufschlagt. Um mit einem Stoßgenerator und einer Auswerteschaltung für ein Mehrphasennetz auszukommen, ist es vorteilhaft, wenn der Stoßgenerator mit einem Zufallsgenerator zur Auswahl der mit einem Stoßspannungsimpuls zu beaufschlagenden Phase des Mehrphasennetzes versehen ist. Um nichtlineare Effekte, wie z.B. Windungsschlüsse durch Teillichtbögen in den Wicklungen ebenfalls erfassen zu können, ist es vorteilhaft, wenn der Scheitelwert des Stoßspannungsimpulses etwa dem der Nennspannung des Versorgungsnetzes entspricht. Die Spannung soll jedoch, um die Wicklungen nicht zu stark zu beanspruchen und dadurch einen Windungsschluß hervorzurufen, auch nicht wesentlich höher als die Scheitelwerte der Netzspannung gewählt werden. Um zu vermeiden, daß sich Streuinduktivitäten stärker auswirken und sich die magnetischen Eigenschaften des Blechpaketes ändern, ist es vorteilhaft, wenn das Spektrum des Stoßspannungsimpulses in einem Frequenzbereich von 50 bis 1 KHz liegt. Ist der Innenwiderstand des Stoßgenerators groß gegenüber der Verbrauchernetzimpedanz, insbesondere einer Motorimpedanz, so ergibt sich durch den Windungsschluß sowohl eine Verbraucherspannungs- wie auch eine Verbraucherstromänderung und damit auch die Möglichkeit, in die Nähe einer Quelle mit eingeprägtem Strom zu kommen. Zur Verwirklichung des Stoßgenerators mit nur wenigen Bauelementen in kompakter Bauweise hat sich eine Anordnung als vorteilhaft herausgestellt, die darin besteht, daß der Stoßgenerator einen über einen Gleichrichter aufladbaren, dem Gleichrichter nachgeschalteten Kondensator enthält, der über einen elektronischen Schalter über die Verbrauchernetzleitungen, insbesondere über die Motorwicklungen, entladbar ist. Um zu vermeiden, daß sich eine gedämpfte Ausgleichsschwingung ergibt, die bereits nach wenigen ms abgeklungen ist, ist es vorteilhaft, wenn den Ausgangsklemmen des Stoßgenerators intern eine Freilaufdiode parallelgeschaltet ist. Hierdurch wird der Stoßspannungsimpuls nach dem ersten Spannungsnulldurchgang abgeschnitten. Eine einfache Ankopplungsmöglichkeit der Auswerteschaltung ist gegeben, wenn der Freilaufdiode die Reihenschaltung eines Spannungsteilers und eines Shunts parallelgeschaltet ist. Eine einfache Auswerteschaltung ergibt sich, wenn die Auswerteschaltung aus einer den Verbraucherstrom und die Verbraucherspannung erfassenden Schaltung und einem jeweils nachgeschalteten Verstärker sowie einer darauffolgenden Multiplizierschaltung besteht, der ein Spitzenwertgleichrichter mit Halteschaltung nachgeschaltet ist. Werden die Verstärker mit einstellbaren Verstärkungsfaktoren versehen, so läßt sich die Auswerteschaltung dem Stoßgenerator und den Motorparametern auf einfache Weise anpassen. Um die Schaltung weiterhin zu vereinfachen, ist es von Vorteil, wenn die Auswerteschaltung einen Mikroprozessor enthält, der den Stoßgenerator zündet und den Vergleich mit Sollwerten durchführt sowie den Befehl zur Blockierung abgibt. Eine weitgehende Verwendung digitaler Techniken mit entsprechender Zuverlässigkeit ist gegeben, wenn ein Anordnung vorgesehen ist, in der Verbraucherstrom- und Verbraucherspannungswerte digitalisiert und nach Multiplikation, hinsichtlich des zeitlichen Verlaufs der Leistung ausgewertet, einen Befehl zur Blockierung abgeben. Hierzu wird erfindungsgemäß ein Verfahren verwendet, bei dem nach Zünden des Stoßgenerators die Spitzenwerte der phasenbezogenen Momentanleistung des Verbrauchernetzes mit zuvor gemessenen Werten verglichen werden und entsprechend einer vorgegeben Abweichung der Befehl zur Blockierung abgeben wird. Werden entsprechende Werte in der Anordnung gespeichert, so können vorteilhafterweise die gemessenen Spitzenwerte der Momentanleistung läuferstellungsabhängig korrigiert werden.

Anhand der Zeichnung wird ein Ausführungsbeispiel gemäß der Erfindung beschrieben.

Es zeigen:
- Fig. 1: eine Schaltung des Stoßgenerators und der Auswerteschaltung,
- Fig. 2: die Spitzenleistung als Funktion der Anzahl der Stoßbeanspruchungen.

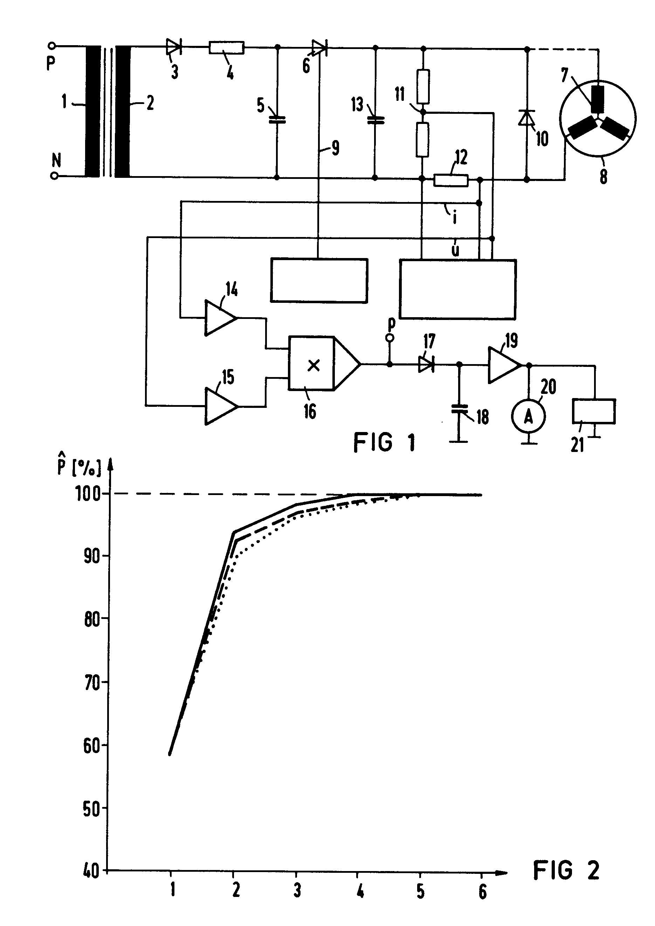

Der in der Fig. 1 dargestellte Stoßgenerator mit der Auswerteschaltung besteht aus dem Trenntransformator 1, dessen Sekundärseite 2 über einen Gleichrichter 3 sowie einen Widerstand 4 mit einem Kondensator 5 in Verbindung steht. Der Kondensator wird über den Thyristor 6 mit den Wicklungen 7 des Motors 8 (Verbraucher) verbunden. Der Anschluß der Zündelektrode des Thyristors 6 trägt das Bezugszeichen 9. Mit 10 ist eine Freilaufdiode bezeichnet, die parallel zu den Ausgangsklemmen und zu Wicklungen 7 des Motors liegt. Ein Spannungsteiler 11 dient zum Abgreifen der Verbraucherspannung und ein Shunt 12 zur Messung des Verbraucherstromes für die Auswerteschaltung. Dem Spannungsteiler 11 ist ein weiterer Kondensator 13 parallelgeschaltet. Die abgenommenen Verbraucherstrom- und Verbraucherspannungswerte werden über Verstärker 14, 15 verstärkt und einer Multiplizierschaltung 16 zugeführt. Ein Spitzenwertgleichrichter 17 richtet die Ausgangsspannung der Multiplizierschaltung 16 gleich. Sie wird in einem Kondensator 18 gespeichert. Über einen Verstärker 19 wird einerseits ein Anzeigeinstrument 20 sowie die Vergleichsschaltung 21, die den Befehl zur Blockierung abgibt, mit der gleich gerichteten Spannung versorgt. Durch die einstellbaren Verstärkungsfaktoren der Verstärker 14, 15 läßt sich die Auswerteschaltung dem Stoßgenerator und den Motorparametern auf einfache Weise anpassen. Da die Spitzenwertanzeige gehalten wird, muß das Halteglied vor dem Zünden des Stoßgenerators zurückgesetzt werden. Die Zündelektrode des Thyristors 6 kann über den Anschluß 9 auf nicht näher dargestellte Weise von einem Mikroprozessor gesteuert werden. Nach Zünden des Thyristors wird über den Motor der Kondensator 5 entladen. Die Frequenz der ungestörten Ausgleichsschwingung wird von den Kapazitäten und von der Induktivität des bzw. der Kabelzuleitungen des Motors bestimmt. Gemessen wird mit der Auswerteschaltung der Spitzenwert der Verbrauchermomentanleistung. Hierbei sind als Parameter die Anzahl der Stöße, die Ausbildung der Phasenwicklung und die Läuferstellung sowie gegebenenfalls ein Windungsschluß zu berücksichtigen. Die Ständer- und Läuferbleche sind vor der ersten Stoßspannungsbeaufschlagung entweder entmagnetisiert oder aber in irgendeiner Richtung vormagnetisiert. Da für kleine magnetische Feldstärken die Magnetisierungskurve des Eisens (Dynamoblech) eine große Steigung aufweist, ist die Induktivität des Motors in diesem Bereich groß (L∼dΦ/di∼dB/dH). Der bei der Stoßspannungsbeaufschlagung fließende Verbraucherstrom wird dadurch begrenzt. Bei der Beaufschlagung mit weiteren unipolaren Stoßspannungsimpulsen steigt der Verbraucherstrom und damit die Verbraucherleistung p̂ an, da L durch die zunehmende Magnetisierung kleiner wird. Etwa nach der 4. Beaufschlagung erhöht sich der Wert von p̂ nicht mehr, siehe Fig. 2. Bei einer möglichen Wiederholrate von 20 ms und einer Impulsdauer von weniger als 2 ms ist somit ein endgültiger Wert nach 82 ms erzielbar. Es ist kein signifikanter Unterschied der gesunden Phasenwicklungen festzustellen.

Die Spitzenwerte der Verbrauchermomentanleistung p̂ zeigen eine Abhängigkeit von der Läuferstellung, welche sich durch vorangehende Messungen ermitteln läßt. Durch Vergleich der Spitzenwerte der gemessenen Verbraucherleistung mit einem Schwellwert, welcher auf der vorangehenden Messung basiert, läßt sich auf den Zustand des Motorzweigs schließen.

Bei allen möglichen Windungs- oder Wicklungsschlüssen treten höhere p̂-Werte auf als beim fehlerfreien Motor. Bei sehr großen Werten besteht ein Klemmenkurzschluß oder ein Kurzschluß im Zuleitungskabel.

## Patentansprüche

1. Anordnung zur Blockierung eines Schaltgerätes, vorzugsweise eines fernbetätigten Schaltgerätes zum Schalten von Verbrauchern, in Abhängigkeit von Verbrauchernetzzustandsdaten, die sich aufgrund einer Fremdspannungseinspeisung in Verbindung mit einer nachgeschalteten Verbraucherstrom- und Verbraucherspannungs Auswerteschaltung (14 - 21) mit Soll- und Istwertvergleich ergeben, **dadurch gekennzeichnet,** daß ein Stoßgenerator (1 - 10) zur Fremdspannungseinspeisung vorgesehen ist und daß die Auswerteschaltung (14 - 21) die Spitzenwerte der Verbrauchermomentanleistung auswertet.

2. Anordnung nach Anspruch 1, **dadurch gekennzeichnet,** daß der Stoßgenerator (1 - 10) alle Phasen eines Mehrphasennetzes gleichzeitig mit einem Stoßspannungsimpuls beaufschlagt.

3. Anordnung nach Anspruch 1, **dadurch gekennzeichnet,** daß der Stoßgenerator (1 - 10) mit einem Zufallsgenerator zur Auswahl der mit einem Stoßspannungsimpuls zu beaufschlagenden Phase eines Mehrphasennetzes versehen ist.

4. Anordnung nach einem der vorhergehenden Ansprüche, **dadurch gekennzeichnet,** daß der Scheitelwert des Stoßspannungsimpulses etwa dem der Nennspannung des zur Versorgung der Verbraucher vorgesehenen Versorgungsnetzes entspricht.

5. Anordnung nach einem der vorhergehenden Ansprüche, **dadurch gekennzeichnet,** daß das Spektrum des Stoßspannungsimpulses in einem Frequenzbereich von 50 bis 1 KHz liegt.

6. Anordnung nach einem der vorhergehenden Ansprüche, **dadurch gekennzeichnet,** daß der Innenwiderstand des Stoßgenerators (1 - 10) groß gegenüber der Verbrauchernetzimpedanz, insbesondere einer Motorimpedanz, ist.

7. Anordnung nach einem der vorhergehenden Ansprüche, **dadurch gekennzeichnet,** daß der Stoßgenerator einen über einen Gleichrichter (3) aufladbaren, dem Gleichrichter nachgeschalteten Kondensator (5) enthält, der über einen elektronischen Schalter (6) über die Verbrauchernetzleitungen, insbesondere über die Motorwicklungen (8), entladbar ist.

8. Anordnung nach Anspruch 7, **dadurch gekennzeichnet,** daß den Ausgangsklemmen des Stoßgenerators (1 - 10) intern eine Freilaufdiode (10) parallelgeschaltet ist.

9. Anordnung nach Anspruch 8, **dadurch gekennzeichnet,** daß der Freilaufdiode (10) die Reihenschaltung eines Spannungsteilers (11) und eines Shunts (12) parallelgeschaltet ist.

10. Anordnung nach einem der vorhergehenden Ansprüche, **dadurch gekennzeichnet,** daß die Auswerteschaltung aus einer den Verbraucherstrom und die Verbraucherspannung erfassenden Schaltung und einem jeweils nachgeschalteten Verstärker (14, 15) sowie einer darauffolgenden Multiplizierschaltung (16) besteht, der ein Spitzenwertgleichrichter (17) mit Halteschaltung nachgeschaltet ist.

11. Anordnung nach einem der vorhergehenden Ansprüche, **dadurch gekennzeichnet,** daß die Auswerteschaltung einen Mikroprozessor enthält, der den Stoßgenerator (1 - 10) zündet und den Vergleich mit Sollwerten durchführt sowie den Befehl zur Blockierung abgibt.

12. Anordnung nach Anspruch 1 oder 2, **dadurch gekennzeichnet,** daß eine Anordnung vorgesehen ist, in der Verbraucherstrom- und Verbraucherspannungswerte digitalisiert und nach Multiplikation, hinsichtlich des zeitlichen Verlaufs der Leistung ausgewertet, den Befehl zur Blockierung abgeben.

13. Verfahren zur Auswertung des Verbraucherstromes und der Verbraucherspannung mittels einer Anordnung nach einem der Ansprüche 1 und 3 bis 10, deren Auswerteschaltung (14 - 21) einen Mikroprozessor enthält, der den Stoßgenerator (1 - 10) zündet und den Vergleich mit Sollwerten durchführt sowie einen Befehl zur Blockierung abgibt, wobei nach Zünden des Stoßgenerators (1 - 10) die Spitzenwerte der phasenbezogenen Momentanleistung des Verbrauchernetzes mit zuvor gemessenen Werten verglichen werden und entsprechend einer vorgegebenen Abweichung der Befehl zur Blockierung abgegeben wird.

14. Verfahren nach Anspruch 13, **dadurch gekennzeichnet,** daß die gemessenen Spitzenwerte der Momentanleistung läuferstellungsabhängig korrigiert werden.

## Claims

1. An arrangement for blocking switchgear, preferably a remote-controlled switchgear for connecting consumers, in dependence on data about the consumer grid status, which result because of a supply of interfering voltage in connection with a subsequently connected consumer current and a consumer voltage evaluating circuit (14-21), with desired value and actual value comparison, characterised in that a pulse generator (1-10) for supplying interfering voltage is provided and in that the evaluating circuit (14-21) evaluates the peak values of the momentary consumer power.

2. An arrangement according to claim 1, characterised in that the pulse generator (1-10) acts on all phases of a polyphase network at the same time with an impact voltage pulse.

3. An arrangement according to claim 1, characterised in that the pulse generator (1-10) is provided with a random generator for selecting the phase of a polyphase network to be acted upon with an impact voltage pulse.

4. An arrangement according to one of the preceding claims, characterised in that the peak value of the impact voltage pulse corresponds approximately to that of the nominal voltage of the supply network provided for supplying the consumer.

5. An arrangement according to one of the preceding claims, characterised in that the spectrum of the impact voltage pulse lies in a frequency range of 50 to 1 KHz.

6. An arrangement according to one of the preceding claims, characterised in that the inner resistance of the pulse generator (10-10) is large compared to the consumer network impedance, in particular of a motor impedance.

7. An arrangement according to one of the preceding claims, characterised in that the pulse generator contains a capacitor (5), able to be charged by way of a rectifier (3), and connected after the rectifier which is able to be discharged by way of an electronic switch (6) by way of the consumer network lines, in particular by way of the motor windings (8).

8. An arrangement according to claim 7, characterised in that a free-wheeling diode (10) is connected in parallel internally to the output terminals of the pulse generator (1-10).

9. An arrangement according to claim 8, characterised in that the series connection of a voltage divider (11) and of a shunt (12) is connected in parallel to the free wheeling diode (10).

10. An arrangement according to one of the preceding claims, characterised in that the evaluating circuit consists of a circuit detecting the consumer current and the consumer voltage and of a respective amplifier (14,15) subsequently connected as well as a multiplier circuit (16) following this, which has connected after it a peak value rectifier (17) with the holding circuit.

11. An arrangement according to one of the preceding claims, characterised in that the evaluating circuit contains a microprocessor, which starts the pulse generator (1-10) and carries out the comparison with desired values as well as delivering the command for blocking.

12. An arrangement according to claim 1 or 2, characterised in that an arrangement is provided, in which the consumer current and consumer voltage values digitised and evaluated after multiplication, with regard to the power-time characteristic, deliver the command for blocking.

13. A method for evaluating the consumer current and the consumer voltage by means of an arrangement according to one of the claims 1 and 3 to 10, the evaluating circuit (14-21) of which contains a microprocessor, which sets off the pulse generator (1-10) and carries out the comparison with desired values as well as a command for blocking, wherein after starting the pulse generator (1-10) the peak values of the phase-related momentary power of the consumer network are compared with values measured before and, corresponding to a predetermined deviation, the command for blocking is delivered.

14. A method according to claim 13, characterised in that the measured peak values of the momentary power are corrected depending on the position of the rotor.

## Revendications

1. Dispositif pour bloquer un appareil de coupure, de préférence un appareil de coupure télécommandé pour le raccordement d'appareils d'utilisation, en fonction de données d'état du réseau d'appareils d'utilisation, qui sont obtenues sur la base d'une injection d'une tension étrangère en liaison avec un dispositif (14-21) d'évaluation du courant et de la tension d'appareils d'utilisation, branché en aval, avec une comparaison valeur de consigne-valeur réelle, caractérisé par le fait qu'il est prévu un générateur de chocs (1-10) pour l'injection de la tension étrangère, et que le circuit d'évaluation (14-21) évalue les valeurs maximales de la puissance instantanée de l'appareil d'utilisation.

2. Dispositif suivant la revendication 1, caractérisé par le fait que le générateur de chocs (1-10) charge simultanément toutes les phases d'un réseau polyphasé avec un signal de tension de choc.

3. Dispositif suivant la revendication 1, caractérisé par le fait que le générateur de chocs (1-10) est pourvu d'un générateur de signaux aléatoires servant à sélectionner la phase d'un réseau polyphasé, qui doit être chargée par une impulsion de tension de choc.

4. Dispositif suivant l'une des revendications précédentes, caractérisé par le fait que la valeur crête de l'impulsion de tension de choc correspond approximativement à celle de la tension nominale du réseau d'alimentation prévu pour alimenter les appareils d'utilisation.

5. Dispositif suivant l'une des revendications précédentes, caractérisé par le fait que le spectre de l'impulsion de tension de choc se situe dans une gamme de fréquences allant de 50 à 1 kHz.

6. Dispositif suivant l'une des revendications précédentes, caractérisé par le fait que la résistance interne du générateur de chocs (1-10) est élevée par rapport à l'impédance du réseau d'appareils d'utilisation, notamment l'impédance d'un moteur.

7. Dispositif suivant l'une des revendications précédentes, caractérisé par le fait que le générateur de chocs comporte un condensateur (5) qui peut être chargé par l'intermédiaire d'un redresseur (3) et qui est branché en aval de ce dernier et qui peut être déchargé par l'intermédiaire d'un interrupteur électronique (6), au moyen de lignes du réseau d'appareils d'utilisation, notamment au moyen des enroulements (8) d'un moteur.

8. Dispositif suivant la revendication 7, caractérisé par le fait qu'une diode à effet unidirectionnel (10) est branchée, d'une manière interne, en parallèle avec des bornes de sortie du générateur de chocs (1-10).

9. Dispositif suivant la revendication 8, caractérisé par le fait que le montage série d'un diviseur de tension (11) et d'un shunt (12) est branché en parallèle avec la diode à effet unidirectionnel (10).

10. Dispositif suivant l'une des revendications précédentes, caractérisé par le fait que le circuit d'évaluation est constitué par un circuit qui détecte le courant et la tension des appareils d'utilisation, et par un amplificateur (14,15), branché respectivement en aval, et est constitué par un circuit multiplicateur (16) situé en aval et en aval duquel est branché un redresseur (17) des valeurs crêtes, équipé d'un circuit de maintien.

11. Dispositif suivant l'une des revendications précédentes, caractérisé par le fait que le circuit d'évaluation comporte un microprocesseur qui amorce le générateur d'ondes de choc (1-10) et exécute la comparaison des valeurs de consigne et délivre l'instruction pour le blocage.

12. Dispositif suivant la revendication 1 ou 2, caractérisé par le fait qu'il est prévu un dispositif dans lequel des valeurs du courant et de la tension des appareils d'utilisation sont numérisées et qui, après multiplication, et moyennant une évaluation de l'allure dans le temps de la puissance, conduisent au déclenchement de l'instruction de blocage.

13. Procédé pour évaluer le courant et la tension d'un appareil d'utilisation d'un dispositif suivant l'une des revendications 1 et 3 à 10, dont le circuit d'évaluation (14-21) comporte un microprocesseur qui amorce le générateur de chocs (1-10) et exécute la comparaison à des valeurs de consigne et délivre une instruction de blocage, et selon lequel après l'amorçage du générateur de chocs (1-10), la valeur de crête de la puissance instantanée, rapportée à la phase, du réseau d'appareils d'utilisation sont comparées à des valeurs mesurées antérieurement et que l'instruction de blocage est délivrée en fonction d'un écart prédéterminé.

14. Procédé suivant la revendication 13, caractérisé par le fait que les valeurs crêtes mesurées de la puissance instantanée sont corrigées en fonction du réglage du rotor.
